# EUROPEAN PATENT SPECIFICATION

(11) **EP 3 570 338 B1**
(45) Date of publication and mention of the grant of the patent: **23.12.2020**
(21) Application number: 19172553.0
(22) Date of filing: 03.05.2019
(51) Int. Cl.: H01L 43/06, G01R 33/07

(54) **SEMICONDUCTOR DEVICE**
HALBLEITERBAUELEMENT
DISPOSITIF À SEMICONDUCTEUR

(30) Priority: 16.05.2018 JP 2018094526
(43) Date of publication of application: 20.11.2019
(73) Proprietor: ABLIC Inc., Chiba-shi, Chiba (JP)
(72) Inventor: HIOKA, Takaaki, Chiba-shi, Chiba (JP)
(74) Representative: Miller Sturt Kenyon

(56) References cited:
- JP-A- S6 370 583
- US-A1- 2014 264 667
- US-B1- 9 299 919
- US-B2- 8 564 083

## Description

### BACKGROUND OF THE INVENTION

### 1. Field of the Invention

The present invention relates to a semiconductor device, and more particularly, to a semiconductor device having a Hall element.

### 2. Description of the Related Art

As a magnetic sensor a Hall element is capable of detecting position or angle without contact, and accordingly has various uses. An example of planar Hall sensors are described in US 9,299,919; and JP S63 70583. Examples of vertical Hall sensors are described in US 8,564,083; US 2014/0264667.

In an actual Hall element, an output voltage is generated even without an application of magnetic field. The voltage which is an output under a magnetic field of zero is called offset voltage. It is considered that the offset voltage is generated by imbalance in potential distribution inside the element caused by, for example, mechanical stress applied to the element from the outside or misalignment occurring in a manufacturing process. In case the Hall element is used as a magnetic sensor, it is required to remove such an offset voltage.

In order to remove or cancel the offset voltage, a spinning current method is generally used.

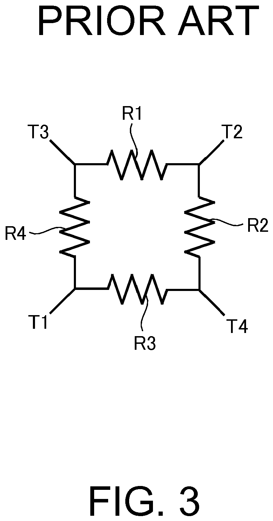

A Hall element can be expressed in an equivalent circuit illustrated in FIG. 3. Specifically, the Hall element is expressed as a bridge circuit in which four terminals T1, T2, T3, and T4 are connected with four resistors R1, R2, R3, and R4.

In a circuit described above, in order to perform the spinning current method, a voltage Vin is first applied between the terminals T1 and T2 with the terminals T1 and T2 being used as drive current supply electrodes, and the terminals T3 and T4 being used as Hall voltage output electrodes. An output voltage Vh+Vos is thereby generated between the terminals T3 and T4. Next, the voltage Vin is applied between the terminals T3 and T4 with the terminals T3 and T4 being used as drive current supply electrodes, and the terminals T1 and T2 being used as Hall voltage output electrodes. An output voltage -Vh+Vos is thereby generated between the terminals T1 and T2. Here, Vh denotes a Hall voltage of the Hall element that is proportional to a magnetic field, and Vos denotes an offset voltage.

Through subtraction (or addition) of the output voltages obtained by supplying the electric currents flowing in the above-mentioned two directions, the offset voltage Vos is canceled, and an output voltage 2Vh that is proportional to the magnetic field can be obtained.

The offset voltage Vos is generated because resistances of the resistors R1, R2, R3, and R4 vary due to the imbalance in potential distribution inside the element but can be canceled through performing the spinning current method as described above.

However, in case the resistances of the resistors R1, R2, R3, and R4 change depending on the voltage application direction, the offset voltage cannot be fully removed.

In a general Hall element, a peripheral portion surrounding an n-type impurity region which is a magnetic sensing portion of the Hall element is a p-type impurity region for separation from other regions (see WO 2007/116823 A1). By the application of a voltage to the drive current supply electrodes to supply an electric current to the magnetic sensing portion, a depletion layer extends along the boundary between the magnetic sensing portion of the Hall element and the peripheral portion thereof.

Because the electric current does not flow through the depletion layer, the electric current is suppressed in a region in which the depletion layer extends in the magnetic sensing portion, and hence the resistance of the portion increases. Moreover, a width of the depletion layer changes depending on the voltage application direction, and hence the resistances of the resistors R1, R2, R3, and R4 of the equivalent circuit illustrated in FIG. 3 change depending on the voltage application direction. Hence the offset voltage cannot be canceled completely even by the execution of the spinning current method.

To address the above-mentioned problem, in Japanese Patent Application Laid-open No. H 08-330646, there is proposed a method in which depletion layer control electrodes are arranged around and above the element, and an applied voltage to each of the electrodes is adjusted, to thereby prevent a depletion layer from extending into the Hall element. Thereby, offset canceling by the spinning current method can be performed.

However, in the method according to Japanese Patent Application Laid-open No. H 08-330646, it is required to use a plurality of depletion layer control electrodes, and a complicated control circuit is additionally required. Accordingly, there are drawbacks in that the chip size increases, and the cost increases, and so on.

### SUMMARY OF THE INVENTION

It is an object of the present invention to provide a semiconductor device including a Hall element which is capable of accurately removing an offset voltage without using a complicated control circuit.

The present invention is directed to a semiconductor device according to the independent device claim 1.

According to the present invention, the magnetic sensing portion having the first depth has an impurity concentration distribution having a peak at the second depth. As a result, when a voltage is applied between two opposing electrodes of the four electrodes to supply an electric current to the magnetic sensing portion, the electric current concentrates and flows around the second depth portion having the highest impurity concentration in the magnetic sensing portion. With the second depth being half the first depth or less, that is, being a shallow portion of the magnetic sensing portion, and the second concentration gradient S2 being mild, a portion extending on the magnetic sensing portion side of a depletion layer generated from the junction between the bottom portion of the magnetic sensing portion and the semiconductor substrate can be prevented from reaching the second depth. Thus, it is possible to prevent suppression of the electric current by the depletion layer which increases the resistance. In other words, resistances among the electrodes can be prevented from changing between the application of the voltage between one pair of opposing electrodes of the four electrodes and the application of the voltage between the other pair of opposing electrodes. Accordingly, the offset voltage can be removed accurately by the spinning current method. Moreover, it is not required to use a depletion layer suppression electrode or a complicated circuit, with the result that a chip size can be reduced, and the cost can be suppressed.

### BRIEF DESCRIPTION OF THE DRAWINGS

Embodiments of the present invention will now be described by way of further example only and with reference to the accompanying drawings, in which:
FIG. 1A is a plan view of a semiconductor device having a Hall element according to an embodiment of the present invention.
FIG. 1B is a cross-sectional view taken along the line L-L of FIG. 1A.
FIG. 2 is a plan view for illustrating another example of the Hall element illustrated in FIG. 1A.
FIG. 3 is an equivalent circuit diagram of a Hall element.

### DESCRIPTION OF THE EMBODIMENTS

The invention will be now described herein with reference to illustrative embodiments.

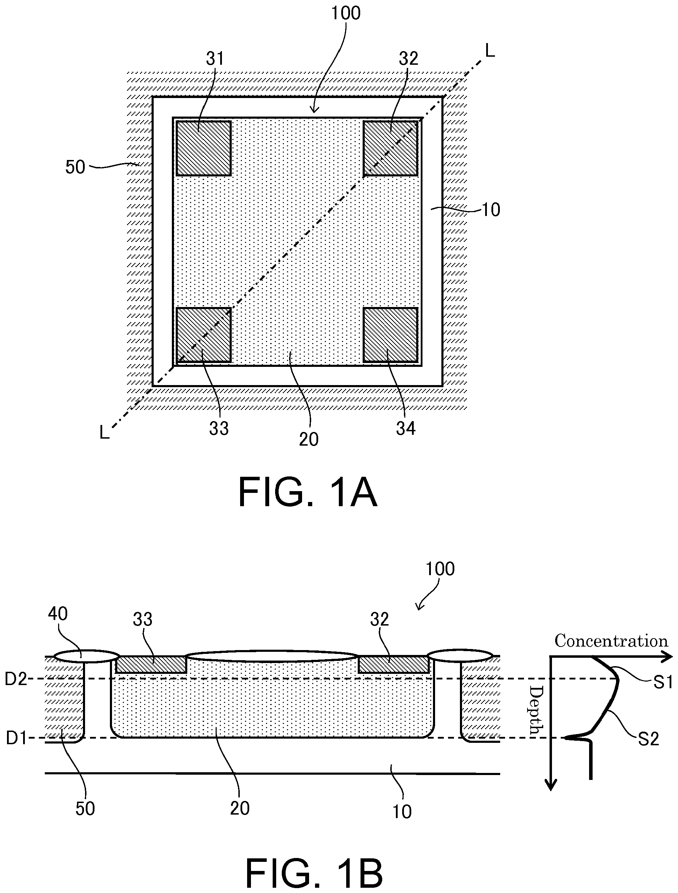

FIG. 1A and FIG. 1B are views for illustrating a semiconductor device having a Hall element 100 according to one embodiment of the present invention in which FIG. 1A is a plan view, and FIG. 1B is a cross-sectional view taken along the line L-L of FIG. 1A. As illustrated in FIG. 1A and FIG. 1B, the semiconductor device according to the embodiment includes a p-type (first conductivity type) semiconductor substrate 10, the Hall element 100 formed in the semiconductor substrate 10, and a p-type element isolation diffusion layer 50 formed to surround the periphery of the Hall element 100.

The Hall element 100 is formed of an n-type (second conductivity type) impurity diffusion layer formed in the semiconductor substrate 10, and includes a magnetic sensing portion 20 having a square shape in plan view, and electrodes 31 to 34 which are provided at respective ends in a surface of the magnetic sensing portion 20, and are each formed of an n-type impurity region having a concentration that is higher than that of the magnetic sensing portion 20.

Moreover, in the Hall element 100, an insulating film 40, for example, SiO₂ film, is formed on the surface of the magnetic sensing portion 20 to cover regions other than regions in which the electrodes 31 to 34 are formed.

On the right side of FIG. 1B, a concentration profile of impurities contained in the p-type semiconductor substrate 10 and the n-type magnetic sensing portion 20 is shown.

As can be seen from the concentration profile, the magnetic sensing portion 20 has the first depth D1 from a surface of the semiconductor substrate 10, has the first concentration gradient S1 in which an n-type impurity concentration increases in a depth direction from the surface of the semiconductor substrate 10 to the second depth D2, which is shallower than the first depth D1, and the second concentration gradient S2 in which the n-type impurity concentration decreases in the depth direction from the second depth D2 to the first depth D1.

Moreover, the second depth D2 is half the first depth D1 or less, and the first concentration gradient S1 is steeper than the second concentration gradient S2.

The magnetic sensing portion 20 having such a concentration distribution is obtained by introducing n-type impurities at the depth D2 in a region to form the magnetic sensing portion 20 of the semiconductor substrate 10 and diffusing the n-type impurities to the depth D1, for example.

It is desired that the depth D2 at which the n-type impurity concentration peaks is from 400 nm to 800 nm, and that the concentration is between 1×10¹⁶ atoms/cm³ and 1×10¹⁷ atoms/cm³. Moreover, it is desired that the depth D1 of the magnetic sensing portion 20 is from about 2 µm to about 5 µm.

The element isolation diffusion layer 50 is formed to be separated from the magnetic sensing portion 20 and electrically isolates the Hall element 100 from other regions (not shown) of the semiconductor substrate 10.

In the other regions (not shown) of the semiconductor substrate 10 which are electrically isolated from the Hall element 100 by the p-type element isolation diffusion layer 50, transistors and other elements forming a circuit are provided to process an output signal from the Hall element 100, or to supply a signal to the Hall element 100. In order to form such an element, n-wells are formed in at least a part of the regions. The n-wells and the magnetic sensing portion 20 which is the n-type impurity diffusion layer can be formed in common steps. The n-wells have thus the same depth and the same concentration distribution as those of the magnetic sensing portion 20. In this manner, according to the embodiment, the magnetic sensing portion 20 can be formed without increasing the number of manufacturing processes.

According to the semiconductor device of the embodiment constituted as described above, by the application of a voltage between the opposing electrodes 32 and 33 of the electrodes 31 to 34 to supply an electric current to the magnetic sensing portion 20, the electric current concentrates and flows through a portion at the second depth D2 which has the highest impurity concentration in the magnetic sensing portion 20. With the second depth D2 being half the first depth D1 or less, that is, being a shallow portion in the magnetic sensing portion 20, and having the mild second concentration gradient S2 described above, a portion extending on the magnetic sensing portion 20 side of a depletion layer generated from the junction between the bottom portion of the n-type magnetic sensing portion 20 and the p-type semiconductor substrate 10 can be prevented from reaching the second depth D2. As a result, it is possible to prevent suppression of the electric current by the existence of the depletion layer which increases the resistance of a path through which the electric current flows. In other words, it is possible to prevent a change in resistance between the application of a voltage between the opposing electrodes 32 and 33 of the four electrodes 31 to 34 and the application of a voltage between the opposing electrodes 31 and 34. Accordingly, an offset voltage can be removed accurately by a spinning current method.

Further, according to the embodiment, with the p-type element isolation diffusion layer 50 and the n-type magnetic sensing portion 20 being separated from each other, and the p-type semiconductor substrate 10 having a concentration that is lower than that of the element isolation diffusion layer 50 being interposed between the element isolation diffusion layer 50 and the magnetic sensing portion 20, extension in a lateral direction of the depletion layer to the magnetic sensing portion 20 can also be suppressed, and the depletion layer can be prevented from affecting the electric current flowing through the magnetic sensing portion 20.

Moreover, it is not required to use a depletion layer suppression electrode or a complicated circuit, with the result that a chip size can be reduced, and the cost can be suppressed.

Further, according to the embodiment, in addition to the above-mentioned effects, the effect of making the Hall element 100 have high sensitivity and low noise can also be obtained. The reason is described below.

It is known that the sensitivity of a Hall element can be increased by increasing the electron mobility of the magnetic sensing portion. In other words, in order to achieve high sensitivity of the Hall element, it is required to decrease the impurity concentration of the magnetic sensing portion of the Hall element.

Meanwhile, in the Hall element, as a sheet resistance thereof is reduced, a noise ratio with respect to the output of the Hall element is reduced.

With the magnetic sensing portion 20 having the first concentration gradient S1 in which the n-type impurity concentration is increased in the depth direction from the surface of the semiconductor substrate 10 to the second depth D2 as described above, the n-type impurity concentration near the surface of the magnetic sensing portion 20 is very small, and a very small electric current thus flows therethrough. Near the surface of the semiconductor substrate 10 (magnetic sensing portion 20), an interface state density and a lattice defect exist, and the electron mobility is thus reduced. However, according to the embodiment, a very small electric current flows near the surface of the magnetic sensing portion 20, and hence a reduction in sensitivity can be prevented.

Further, in the Hall element 100, the insulating film 40 is formed to cover the regions other than the regions in which the electrodes 31 to 34 are formed in the surface of the magnetic sensing portion 20 as described above. As a result, the electric current can be prevented more reliably from flowing through the region having low electron mobility at the surface of the magnetic sensing portion 20. As a result, the reduction in sensitivity can be suppressed.

Moreover, with the maximum peak concentration of the magnetic sensing portion 20 being from about 1×10¹⁶ atoms/cm³ to about 1×10¹⁷ atoms/cm³, which is not very high, the electron mobility can be increased, and the sensitivity can be increased.

Further, the concentration of the magnetic sensing portion 20 is set to be relatively low to increase the electron mobility as described above, but with the depth of the magnetic sensing portion 20 being from about 2 µm to about 5 µm, which is relatively deep, in correspondence thereto, the sheet resistance of the Hall element 100 can be decreased, the ratio of noise to the output signal of the Hall element 100 is reduced, and stable output can be obtained.

It is apparent that the present invention is not limited to the above embodiments but may be modified and changed without departing from the scope of the invention.

For example, the first conductivity type and the second conductivity type, which are the P type and the N type, respectively, in the above-mentioned embodiment, may be switched so that the first conductivity type represents the N type while the second conductivity type represents the P type.

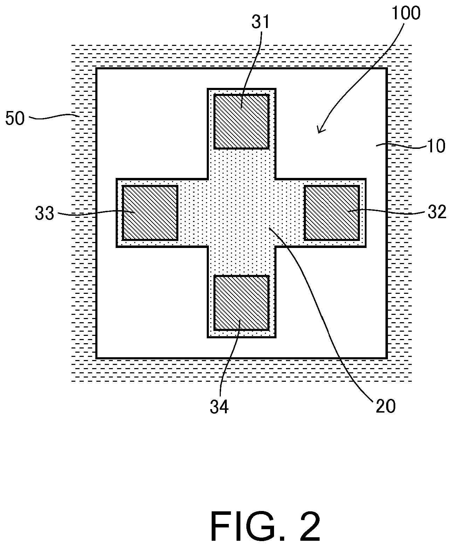

Moreover, in the above-mentioned embodiment, there has been described the example in which the magnetic sensing portion 20 has a square shape in plan view. However, the shape of the magnetic sensing portion 20 is not limited thereto and may be a cross shape as illustrated in FIG. 2, for example.

## Claims

1. A semiconductor device, comprising:
a semiconductor substrate (10) of a first conductivity type; and
a Hall element (100) formed in the semiconductor substrate (10),
the Hall element (100) comprising:
a magnetic sensing portion (20) formed of an impurity diffusion layer of a second conductivity type formed in the semiconductor substrate (10), and having four ends in plan view; and
four electrodes (31-34) provided at the respective four ends in a surface of the magnetic sensing portion (20), and each formed of an impurity diffusion layer of the second conductivity type having a concentration that is higher than a concentration of the magnetic sensing portion (20),
the impurity diffusion layer which forms the magnetic sensing portion (20) having a first depth (D1) from a surface of the semiconductor substrate (10), having a first concentration gradient (S1) in which a concentration of impurities of the second conductivity type increases in a depth direction from the surface of the semiconductor substrate (10) to a second depth (D2) which is shallower than the first depth (D1), and having a second concentration gradient (S2) in which the concentration of the impurities of the second conductivity type decreases in the depth direction from the second depth (D2) to the first depth (D1), the second depth (D2) being half the first depth (D1) or less, the first concentration gradient (S1) being steeper than the second concentration gradient (S2); and
**characterized in that** the concentration of the impurities of the second conductivity type in the magnetic sensing portion (20) has a peak between depths of 400 nm and 800 nm from the surface of the semiconductor substrate (10), the concentration at the peak being from 1×10¹⁶ atoms/cm³ to 1×10¹⁷ atoms/cm³, the magnetic sensing portion (20) having a depth of from 2 µm to 5 µm.

2. The semiconductor device according to claim 1, wherein the magnetic sensing portion (20) has one of a square shape and a cross shape in plan view.

3. The semiconductor device according to according to any one of the preceding claims, further comprising an element isolation diffusion layer (50) of the first conductivity type formed in the semiconductor substrate (10) so as to surround a periphery of the magnetic sensing portion and to be separated from the magnetic sensing portion (20), the element isolation diffusion layer (50) having a concentration that is higher than a concentration of the semiconductor substrate (10).

4. The semiconductor device according to according to any one of the preceding claims, wherein the surface of the magnetic sensing portion (20) is covered with an insulating film (40) except for regions in which the four electrodes (31-34) are provided.

5. The semiconductor device according to claim 4, wherein the surface of the semiconductor substrate (10) is also covered with an insulating film.

## Patentansprüche

1. Halbleiterbauelement, umfassend:
ein Halbleitersubstrat (10) einer ersten Leitfähigkeitsart; und
ein Hall-Element (100), das in dem Halbleitersubstrat (10) gebildet ist,
wobei das Hall-Element (100) umfasst:
einen magnetischen Erfassungsabschnitt (20), der aus einer Störstellendiffusionsschicht einer zweiten Leitfähigkeitsart gebildet ist, die in dem Halbleitersubstrat (10) gebildet ist, und vier Enden in Draufsicht aufweist; und
vier Elektroden (31-34), die an den entsprechenden vier Enden in einer Oberfläche des magnetischen Erfassungsabschnitts (20) bereitgestellt sind und jeweils aus einer Störstellendiffusionsschicht der zweiten Leitfähigkeitsart gebildet sind, mit einer Konzentration, die höher als eine Konzentration des magnetischen Erfassungsabschnitts (20) ist,
wobei die Störstellendiffusionsschicht, die den magnetischen Erfassungsabschnitt (20) bildet, eine erste Tiefe (D1) von einer Oberfläche des Halbleitersubstrats (10) aufweist, einen ersten Konzentrationsgradienten (S1) aufweist, in dem eine Konzentration von Störstellen der zweiten Leitfähigkeitsart in einer Tiefenrichtung von der Oberfläche des Halbleitersubstrats (10) zu einer zweiten Tiefe (D2) hin zunimmt, die seichter als die erste Tiefe (D1) ist, und einen zweiten Konzentrationsgradienten (S2) aufweist, in dem die Konzentration der Störstellen der zweiten Leitfähigkeitsart in der Tiefenrichtung von der zweiten Tiefe (D2) zu der ersten Tiefe (D1) hin abnimmt, wobei die zweite Tiefe (D2) die Hälfte der ersten Tiefe (D1) oder weniger ist, wobei der erste Konzentrationsgradient (S1) steiler als der zweite Konzentrationsgradient (S2) ist; und
**dadurch gekennzeichnet, dass**
die Konzentration der Störstellen der zweiten Leitfähigkeitsart in dem magnetischen Erfassungsabschnitt (20) eine Spitze zwischen Tiefen von 400 nm und 800 nm von der Oberfläche des Halbleitersubstrats (10) hat, wobei die Konzentration bei der Spitze 1×10¹⁶ Atome/cm³ bis 1×10¹⁷ Atome/cm³ ist, wobei der magnetische Erfassungsabschnitt (20) eine Tiefe von 2 µm bis 5 µm aufweist.

2. Halbleiterbauelement nach Anspruch 1, wobei der magnetische Erfassungsabschnitt (20) eines von einer quadratischen Form und einer Kreuzform in Draufsicht aufweist.

3. Halbleiterbauelement nach einem der vorstehenden Ansprüche, weiter umfassend eine Elementisolationsdiffusionsschicht (50) der ersten Leitfähigkeitsart, die in dem Halbleitersubstrat (10) so gebildet ist, dass sie einen Umfang des magnetischen Erfassungsabschnitts umgibt und von dem magnetischen Erfassungsabschnitt (20) getrennt ist, wobei die Elementisolationsdiffusionsschicht (50) eine Konzentration aufweist, die höher als eine Konzentration des Halbleitersubstrats (10) ist.

4. Halbleiterbauelement nach einem der vorstehenden Ansprüche, wobei die Oberfläche des magnetischen Erfassungsabschnitts (20) mit einem Isolierfilm (40) bedeckt ist, mit Ausnahme von Bereichen, in welchen die vier Elektroden (31-34) bereitgestellt sind.

5. Halbleiterbauelement nach Anspruch 4, wobei die Oberfläche des Halbleitersubstrats (10) auch mit einem Isolierfilm bedeckt ist.

## Revendications

1. Dispositif à semi-conducteur, comprenant :
un substrat de semi-conducteur (10) d'un premier type de conductivité ; et
un élément de Hall (100) formé dans le substrat de semi-conducteur (10),
l'élément de Hall (100) comprenant :
une partie de détection magnétique (20) formée d'une couche de diffusion d'impuretés d'un second type de conductivité formée dans le substrat de semi-conducteur (10) et ayant quatre extrémités dans une vue en plan ; et
quatre électrodes (31-34) prévues sur les quatre extrémités respectives dans une surface de la partie de détection magnétique (20) et formée chacune d'une couche de diffusion d'impuretés du second type de conductivité ayant une concentration qui est plus élevée qu'une concentration de la partie de détection magnétique (20),
la couche de diffusion d'impuretés qui forme la partie de détection magnétique (20) ayant une première profondeur (D1) à partir d'une surface du substrat semi-conducteur (10), ayant un premier gradient de concentration (S1) dans lequel une concentration d'impuretés du second type de conductivité augmente dans une direction de profondeur de la surface du substrat semi-conducteur (10) vers une seconde profondeur (D2) qui est moins profonde que la première profondeur (D1) et ayant un second gradient de concentration (S2) dans lequel la concentration des impuretés du second type de conductivité baisse dans la direction de profondeur de la seconde profondeur (D2) à la première profondeur (D1), la seconde profondeur (D2) faisant la moitié de la première profondeur (D1) ou moins, le premier gradient de concentration (S1) étant plus pentu que le second gradient de concentration (S2) ; et
**caractérisé en ce que**
la concentration des impuretés du second type de conductivité dans la partie de détection magnétique (20) a une crête entre des profondeurs de 400 nm et 800 nm à partir de la surface du substrat semi-conducteur (10), la concentration à la crête étant de 1x10¹⁶ atomes/cm³ à 1x10¹⁷ atomes/cm³, la partie de détection magnétique (20) ayant une profondeur de 2 µm à 5 µm.

2. Dispositif à semi-conducteur selon la revendication 1, dans lequel la partie de détection magnétique (20) a l'une d'une forme de carré et d'une forme de croix dans une vue en plan.

3. Dispositif à semi-conducteur selon l'une quelconque des revendications précédentes, comprenant en outre une couche de diffusion d'isolation d'élément (50) du premier type de conductivité dans le substrat semi-conducteur (10) de manière à entourer une périphérie de la partie de détection magnétique et pour être séparée de la partie de détection magnétique (20), la couche de diffusion d'isolation d'élément (50) ayant une concentration qui est plus élevée qu'une concentration du substrat semi-conducteur (10).

4. Dispositif à semi-conducteur selon l'une quelconque des revendications précédentes, dans lequel la surface de la partie de détection magnétique (20) est couverte d'un film isolant (40) sauf dans des régions dans lesquelles les quatre électrodes (31-34) sont prévues.

5. Dispositif à semi-conducteur selon la revendication 4, dans lequel la surface du substrat semi-conducteur (10) est également couverte d'un film isolant.
